# EUROPÄISCHE PATENTSCHRIFT

(11) **EP 0 520 193 B1**
(45) Veröffentlichungstag und Bekanntmachung des Hinweises auf die Patenterteilung: **09.04.1997**
(21) Anmeldenummer: 92108749.0
(22) Anmeldetag: 24.05.1992
(51) Int. Cl.: G01R 31/12, G01R 31/18, G01R 23/16

(54) **Verfahren zum Messen von Teilentladungen**
Method for measuring partial discharges
Procédé pour messurer des décharges partielles

(30) Priorität: 24.06.1991 DE 4120821
(43) Veröffentlichungstag der Anmeldung: 30.12.1992
(73) Patentinhaber: MWB MESSWANDLER-BAU AG, D-96050 Bamberg (DE)
(72) Erfinder: Pfeiffer, Wolfgang, Prof.Dr.-Ing., W-6109 Mühltal 1 (DE); Koch, Hermann, Dr.-Ing., W-6074 Urberach (DE); Buchalla, Harald, Dipl.-Ing., W-6100 Darmstadt (DE)
(74) Vertreter: Hufnagel, Walter, Dipl.-Ing., Dipl.-Wirtsch.-Ing.

(56) Entgegenhaltungen:
- DE-A- 3 148 735
- DE-A- 4 008 143

## Beschreibung

Die vorliegende Erfindung bezieht sich auf Verfahren zum Messen von Teilentladungen an einer Vielzahl von gleichartigen Prüflingen gemäß dem Oberbegriff des Anspruches 1.

Die Messung von Teilentladungen bereitet insbesondere deshalb Schwierigkeiten, weil zum einen die erhaltenen Teilentladungsimpulse, im folgendem TE-Impulse genannt , relativ klein, die angelegte Prüfspannung sehr hoch und außerdem mit den vom Netz, der Meßschaltung, der Umgebung oder dgl. eingekoppelten Störsignalen überlagert sind. Die Auswertung eines gemessenen und beispielsweise mit einem Speicheroszilloskop, insbesondere mit einem Digital-Speicheroszilloskop, dargestellten TE-Impulse,erfordert daher eine große Erfahrung in der Erkennung von Störsignalen und ist demgemäß relativ arbeitsintensiv und anstrengend. Eine schnelle Beurteilung einer Serienfertigung von Bauteilen eines bestimmten Typs oder sogar eine Automatisierung des Meß- und Auswertevorgangs von Teilentladungen ist daher nicht möglich oder sehr ungenau. Zur Erhöhung der Störunterdrückung kann zwar ein schmalbandig ausgelegtes Meßsystem verwendet werden; jedoch gehen dabei zwangsläufig auch Informationen über den Verlauf des TE-Impulses verloren, so daß eine Unterscheidung zwischen TE-Impulsen und Störimpulsen nicht mehr möglich ist.

Mit der vorliegenden Erfindung soll die Aufgabe gelöst werden, ein Verfahren anzugeben, mit dem eine Messung und Auswertung von TE-Impulsen schnell, insbesondere automatisch und unabhängig von auftretenden Störspannungen, mit hoher Genauigkeit durchführbar ist. Gelöst wird diese Aufgabe durch die im Anspruch 1 angegebenen Verfahrensschritte.

Durch die insbesondere durch eine Fourier-Transformation vorgenommene Transformation der TE-Impulse vom Zeitbereich in den Frequenzbereich, die Erzeugung eines Referenz-Impulses und den Vergleich der Prüflings-TE-Impulse mit dem Referenz-TE-Impuls-Spektrum, unter vorheriger Anpassung der Amplitudenwerte des Prüflings-TE-Impulses, kann auf einfache Weise festgestellt werden, ob TE-Impulse mit oder ohne Störimpulse vorliegen. Die vorhandenen und ermittelten Störsignale können rechnerisch kompensiert oder unterdrückt werden, so daß auch ein Prüflings-TE-Impuls mit aufgeprägten Störsignalen für die Auswertung herangezogen werden kann. Dadurch können Serienprodukte eines einheitlichen Bautyps schnell und automatisch durch die erfindugnsgemäße TE-Impulsmessung geprüft werden.

Weitere vorteilhafte Einzelheiten der Erfindung sind in den Unteransprüchen angegeben und werden nachfolgend anhand der in der Zeichnung veranschaulichten Ausführungsbeispiele näher beschrieben.
Es zeigen:
- Fig. 1: eine Prinzipdarstellung eines Messplatzes zur Ausübung des erfindungsgemäßen Verfahrens,
- Fig. 2 bis 8: Diagramme verschiedener TE-Impulse.

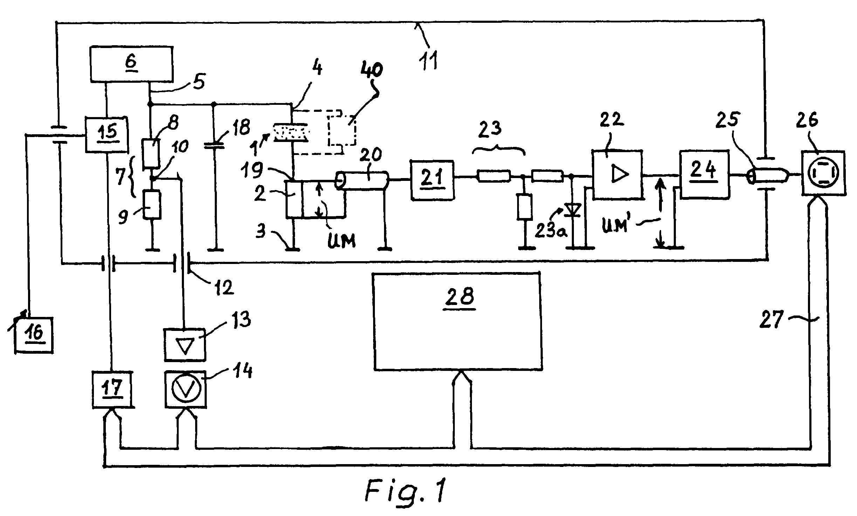

Wie die Fig. 1 zeigt, ist ein Prüfling 1 über eine beim Ausführungsbeispiel als Meßwiderstand 2 ausgebildete Meßimpedanz von beispielsweise 50 bis 200 Ohm nach Masse (3) geschaltet.

Als Meßimpedanz kann auch eine Induktivität oder die Parallel- oder Reihenschaltung eines ohmschen Widerstandes mit einer Induktivität vorgesehen sein. Am Eingang 4 des Prüflings 1 ist der Ausgang 5 eines Hochspannungserzeugers 6 angeschlossen, der einen Prüfimpuls, beispielsweise eine Prüf-Hochspannung, definierter Wellenform ausgeben kann und der über einen Spannungsteiler 7 mit seinen Teilwiderständen 8 und 9 ebenfalls nach Masse 3 geschaltet ist. Der Spannungsteiler 7 teilt die angelegte Prüf-Hochspannung beispielsweise im Verhältnis 1:1000. Vom Teilerpunkt 10 des Spannungsteilers 7 führt eine Leitung durch eine in einem Abschirmgehäuse 11 vorgesehene Durchführung 12 über einen Isolierverstärker 13 zu einem Spannungsmesser, insbesondere zu einem Digitalvoltmeter 14.

Die Spannung des Hochspannungserzeugers 6 ist über eine Steuereinheit 15, beispielsweise zwischen 0 und 12 kV, in Stufen oder stufenlos einstellbar. Die Steuereinheit 15 ist von außen über eine Handsteuereinrichtung 16 und/oder elektronisch über eine Interface-Steuerung 17 digital ansteuerbar.

Der Ausgang 5 des Hochspannungserzeuges 6 ist vorzugsweise über einen Koppelkondensator 18 an Masse 3 gelegt.

Der Hochpunkt 19 des Meßwiderstandes 2 liegt über eine Koppelleitung 20, beispielsweise über ein Koaxialkabel, mit einem Wellenwiderstand von etwa 50 Ohm, sowie ggf. über einen Hochpaß 21, beispielsweise einem Hochpaß 6. Ordnung, an einem Breitband-Meßverstärker 22. Der Hochpaß 21 ist bevorzugt so ausgelegt, daß eine im ausgekoppelten TE-Impuls vorhandene, vom Hochspannungserzeuger 6 stammende 50 Hertz-Netzfrequenz unterdrückt wird. Die Eckfrequenz des Hochpasses 21 beträgt etwa 1,0 bis 1,5 kHz. Falls erforderlich, kann vor dem Breitband-Meßverstärker 22 noch wenigstens ein Eingangsspannungsteiler 23 vorgesehen sein. Bei mehreren Eingangsspannungsteilern 23 ist die Einstellung unterschiedlicher Verstärkungsfaktoren möglich. Weiterhin wird der Breitband-Meßverstärker 22 durch eine beim Ausführungsbeispiel als Schutzdiode ausgebildete Eingangsschutzbeschaltung 23 a gegen Überspannungen, insbesondere gegen impulsförmige Überspannungen kleiner Anstiegszeiten,geschützt.

Als Eingangsstufe für den Breitband-Meßverstärker 22 dient bevorzugt ein Differenzverstärker, insbesondere mit einem FET-Eingang, oder ein entsprechender Operationsverstärker mit hoher Gleichtaktunterdrückung.

Dem Breitband-Meßverstärker 22 ist ein Tiefpaß in Form eines Antialiasingfilters 24 nachgeschaltet. Beispielsweise kann dessen obere Eckfrequenz zwischen 3 MHz und 10 MHz,insbesondere bei 5 MHz liegen. Er ist über eine Koaxialdurchführung 25 mit dem Eingang eines Analog-/Digital-Wandlers mit nachfolgendem Digitalspeicher, beispielsweise dem Digitalspeicheroszilloskop 26 verbunden, der seinerseits über einen Interface-Bus 27 mit einem Rechner 28, insbesondere mit einem Mikrocomputer, mit möglichst hoher Taktfrequenz von beispielsweise 20 MHz bis 33 MHz, verbunden ist.

Über den Interface-Bus 27 sind außerdem sowohl das Digitalvoltmeter 14 als auch über die Interface-Steuerung 17 die Steuereinheit 15 angeschlossen, die damit ebenfalls mit dem Rechner 28 verbunden und von diesem ansteuerbar ist. Im Rechner 28 ist unter anderem ein Programm zur Transformation eines Zeitbereiches in einen Frequenzbereich, beispielsweise zur Fourier-Transformation, insbesondere zur Fast-Fourier-Transformation, der vom Analog-/Digital-Wandler mit nachfolgendem Digitalspeicher bzw. der vom Digitalspeicheroszilloskop 26 eingelesenen Daten des eingegebenen TE-Impulses enthalten. Dadurch kann das erhaltene digitalisierte Impuls-Zeit-Diagramm in ein Frequenzspektrum umgerechnet werden.

Die allgeim bekannte Fast-Fourier-Transformation ist an die Meßplatzspezifischen Datenformate angepaßt, um die Rechenzeit zu reduzieren. Durch den Rechner 28 wird außerdem die Ladung eines Impulses berechnet und es werden die erhaltenen Werte zwecks Weiterverarbeitung gespeichert. Weiterhin enthalten der Rechner 28 bzw. das Programm Routinen zur Erkennung und Beseitigung von Störsignalen, bevorzugt mittels der Auto- und Kreuzkorrelationsrechnung.

Der Ablauf des Meßverfahrens erfolgt mit diesem Meßaufbau im wesentlichen wie folgt:

Über die Handsteuereinrichtung 16 oder den Rechner 28 wird der Hochspannungserzeuger 6 angesteuert. Dieser gibt darauf an seinem Ausgang 5 eine Prüfspannung definierter Wellenform als Prüfimpuls mit von Impuls zu Impuls steigender Spannung an den Prüfling 1 ab. Beim Auftreten von Teilentladungen fließt über den Meßwiderstand 2 ein entsprechender Strom nach Masse 3 ab. Am Hochpunkt 19 des Meßwiderstandes 2 entsteht ein Spannungsabfall, der als Meßspannung UM ausgekoppelt und über das Koaxialkabel 20, den Hochpaß 21, den Eingangsspannungsteiler 23 und der Eingangsschutzbeschaltung 23 a dem Breitband-Meßverstärker 22 zugeleitet wird. Die von diesem ausgegebene verstärkte Meßspannung UM' wird über das Antialiasingfilter 24 und die Durchführung 25 an den Eingang eines Analog-/Digital-Wandlers mit nachfolgendem Speicher bzw. an den Eingang des Digitalspeicheroszilloskops 26 angelegt. In diesem wird der Kurvenzug digitalisiert und gespeichert. Die digitalen Werte werden über den Interface-Bus 27 dem Rechner 28 eingegeben und von diesem durch diskrete Fourier-Transformation oder Fast-Fourier-Transformation in den Frequenzbereich transformiert. Dazu werden bekanntlich die Beträge der diskreten Frequenzen errechnet. Bei einer Abtastfrequenz von beispielsweise 20 MHz und einer Übertragung von 2048 Meßpunkten wird unter Berücksichtigung des Gleichspannungsanteils und der Symmetrie der Fast-Fourier-Transformation-FFT- das Frequenzspektrum des Impulses als Frequenzamplituden von etwa 10 kHz bis 10,23 MHz im Abstand von 10 kHz dargestellt. Wegen des als Antialiasing-Filter ausgeführten Tiefpasses 24 dürfen jedoch nur die Frequenzen unterhalb dessen Eckfrequenz, also beispielsweise unterhalb 5 MHz, zur Signalbewertung herangezogen werden. Das berechnete Frequenzspektrum kann vom Rechner 28 zur Anzeige an einen Bildschirm ausgegeben werden.

Zur Vorbereitung des automatisierten Meßvorgangs werden zunächst mehrere Muster-TE-Impulse manuell oder mit der Meßvorrichtung automatisch aufgenommen und für jede Amplitude des Frequenzspektrums über eine Schar gemittelt. Diese erhaltenen Daten werden abgespeichert und dienen als Referenz-TE-Impuls-Spektrum für eine Prüflingsgruppe, beispielsweise für Optokoppler, Transformatoren oder gedruckte Schaltungsplatten jeweils eines bestimmten Bautyps, d.h. er dient als Vergleichsgrundlage, also als Referenz für die an einem Prüfling anfallenden Prüflings-TE-Impulse.

Alternativ dazu können auch synthetisch erzeugte Impulse zur Generierung des Referenz-TE-Impuls-Spektrums herangezogen werden, beispielsweise indem sie als mathematische Funktion oder in Form einer Wertetabelle direkt in den Rechner 28 eingegeben werden oder in dem an Stelle der im Prüfling entstehenden TE-Impulse mittels eines Muster-ImpulsGenerators 40, der vorzugsweise bei ausgeschalteter Prüfspannung dem Prüfling insbesondere parallel geschaltet wird - in Fig. 1 durch gestrichelte Linien angedeutet - in den Prüfaufbau eingeprägt werden.

Da die Amplituden der einzelnen Frequenzen des Frequenzspektrums sich mit der Amplitude eines TE-Impulses ändern, ist eine Normierung der Amplitudenwerte des Frequenzspektrums notwendig. Dazu wird für jeden gemessenen TE-Impuls ein 100%-Amplitudenwert berechnet und es werden die Amplituden aller Frequenzen auf diesen bezogen.

Für die Bildung des 100%-Amplitudenwertes werden bevorzugt nur solche Frequenzen verwendet, die für das Referenz-TE-Impuls-Spektrum charakteristisch sind. So können beispielsweise, ausgehend von einem Rechteckimpuls als Eingangssignal und einer (sin*x)/x-Funktion als Frequenzspektrum, die Amplituden der Frequenzen von 10 kHz bis 100 kHz und von 3,01 bis 3,1 MHz als Bezugsgröße gewählt werden.

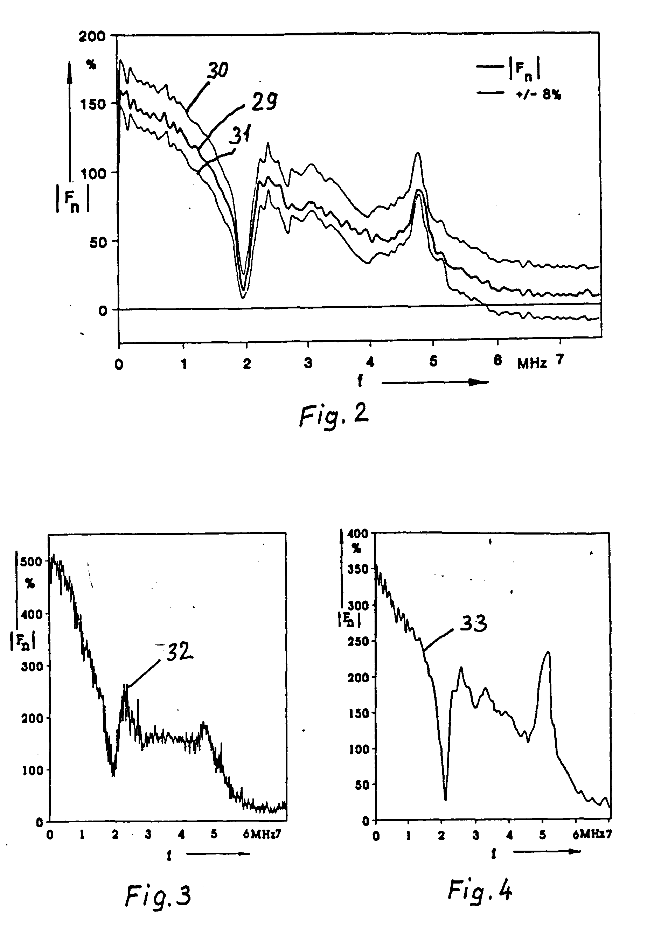

Die erste Nullstelle der Funktion (sin*x)/x beträgt für einen Meßaufbau der genannten Art beispielsweise 2 MHz. Ein typisches Frequenzspektrum an getesteten vergossenen Niederspannungstransformatoren zeigt die in Fig. 2 dargestellte, dick ausgezogene Linie 29. Die Linien 30 und 31 oberhalb bzw. unterhalb der Linie 29 zeigen den gewählten Toleranzbereich an, in dem das Frequenzspektrum eines Prüflings-TE-Impulses liegen darf. Beim dargestellten Beispiel ist der Toleranzbereich +/-8%, bezogen auf die Linie 29. Zur Mittelwertbildung eines Referenz-TE-Impuls-Spektrums werden beispielsweise 5 TE-Impulse benötigt. Durch die gewählte enge Toleranz ist die Trennung von TE-Impulsen und Störimpulsen möglich. Eine automatische Serienprüfung von Bauteilen, die mit dem Prüfling, der zur Referenz-TE-Impuls-Spektrums-Bildung herangezogen wurde, typengleich sind, ist so einfach und sicher möglich.

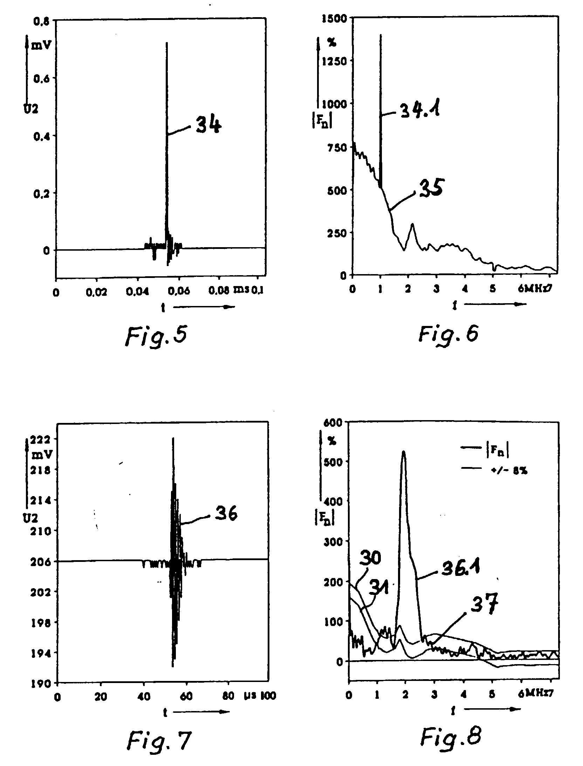

An Störimpulsen können grundsätzlich folgende Störsignale auftreten:
a) Digitales Quantisierungsrauschen, ausgelöst durch die Analog-Digital-Wandlung im Digitalspeicheroszilloskop 26. Dies wirkt sich besonders stark bei konstanten Werten im Zeitbereich, beispielsweise als Rauschwerte um die Nulllinie aus. Ein TE-Impuls dieser Art ist in Fig. 3 in Form eines Frequenzspektrums 32 dargestellt. Der Einfluß des Quantisierungsrauschens kann durch Bewerten der Impulse mit einer Fensterfunktion verringert werden. Die Fast-Fourier-Transformation eines solchen Impulses zeigt die Fig. 4 in Form eines Frequenzspektrums 33.
b) Periodische Störsignale, wie beispielsweise in Fig. 5 dargestellt. Sie zeigt ein einen TE-Impuls überlagerndes Störsignal 34 mit einer Frequenz von 1 MHz in der Zeitdarstellung. Das Störsignal 34.1 ist im Frequenzspektrum 35 dieses TE-Impulses, also nach der Fourier-Transformation, in Fig. 6 deutlich erkennbar. Diese Störung kann durch eine Korrekturroutine des Rechnerprogramms in einfacher Weise ausgeblendet werden. Hierzu werden die Impulse auf beispielsweise markante Spitzen des Frequenzspektrums, die größer sind als der Toleranzbereich, untersucht und diese werden dann den Beträgen der benachbarten Spektralanteile angepaßt. Weitergehend können ggf. periodische Störsignale mittels einer Signalverarbeitung, vorzugsweise einer Autokorrelationsrechnung, erkannt werden und mittels einer Korrekturroutine, vorzugsweise eines digitalen Filters, beseitigt werden.
c) Breitband-Störsignale sind in der Regel kaum vermeidbar. Durch den Vergleich der Prüflings-TE-Impulse mit dem Referenz-TE-Impuls-Spektrum ist jedoch eine Erkennung derselben insofern möglich, als beispielsweise durch eine Programmroutine ein Prüflings-TE-Impuls erst dann als solcher gewertet wird, wenn eventuelle Störsignale gemäß a) und b) beseitigt sind und mehr als ein bestimmter Prozentsatz, beispielsweise 75% bis 95%, der Beträge der Spektralanteile innerhalb des Toleranzbereiches liegen.
d) Rauschen: Bei sehr kleinen TE-Ladungsstärken ist dem Nutzsignal ein starkes Rauschen überlagert. Durch eine Verrechnung der Impulse, vorzugsweise eine Kreuz-Korrelationsrechnung, mit einem rauscharmen, eventuell auch synthetisch erzeugten Musterimpuls, kann bei Bedarf der Störabstand der TE-Impulse verbessert werden.
e) Schalt-Störsignale 36, wie sie beispielsweise durch das Einschalten des Motors zur Einstellung der Prüfspannung des Hochspannungserzeugers 6 - oder auch durch Relaisoder Schützsteuerungen,Leuchtstofflampen, Bimetallschalter oder dgl. - auftreten, zeigen ebenfalls einen vom Referenz-TE-Impuls-Spektrum stark abweichenden Zeitverlauf, wie in Fig. 7 gezeigt ist. Entsprechend ist auch das in Fig. 8 dargestellte Frequenzspektrum 36.1 - also nach der Fourier-Transformation - als deutlich von dem zwischen den Linien 30 und 31 Liegenden Toleranzbereich eines Referenz-Spektrums abweichend erkennbar. Ein derartiger Störimpuls 36.1 wird also ebenfalls sicher erkannt und somit der gemessene Impuls der Fig. 8 - dargestellt als TE-Impuls-Spektrum 37 - nicht als Prüflings-TE-Impuls gewertet.

Das automatische Messen von Prüflingen beginnt mit kleiner Prüfspannung, die pro Sekunde, beispielsweise um 100 V, erhöht wird. Dies führt beispielsweise zu einer Meßauflösung von 50 V und bei einer maximalen Prüfspannung von 12 kV beträgt die Prüfzeit 2 Minuten. Wird ein Prüflings-TE-Impuls nach Störunterdrückung, Anpassung und Vergleich mit dem Referenz-TE-Impuls-Spektrum als solcher erkannt, so kann noch seine Ladung, beispielsweise durch Integration von abgetasteten Spitzenwerten, festgestellt und es können sowohl diese als auch die zugehörige Einsatzspannung abgespeichert werden. Da oft bei Stückprüfungen die Prüfspannung vorgegeben ist, kann die automatische TE-Messung auf die Erkennung und Speicherung der Einsatzspannung der gewerteten Prüflings-TE-Impulse beschränkt sein.

Die automatische Messung kann, wie bereits angegeben, durch die an sich bekannte Fast-Fourier-Transformation sehr schnell durchgeführt werden, wobei eine weitere Verkürzung der Meßzeit durch entsprechende Auswahl von digitalen Einheiten mit hoher Taktfrequenz oder durch spezialisierte Bauelemente, beispielsweise durch digitale Signalprozessoren, möglich ist.

Es kann zweckmäßig sein, als Meßimpedanz 2 einen koaxialen Rohrwiderstand oder vorzugsweise einen Reusenwiderstand zu verwenden. Auch kann es günstig sein, die als Meßwiderstand ausgebildete Meßimpedanz als Metallschichtwiderstand auszuführen.

Auch wenn die veränderliche Prüfspannung bevorzugt im unteren Hochspannungsbereich bis ca. 12 kV liegt, ist die vorliegende Erfindung nicht auf diesen Prüfspannungsbereich beschränkt. Zur Lösung der erfindungsgemäßen Aufgabe können mit gleichen oder vergleichbaren Vorteilen auch Prüfspannungen wesentlich höherer Spannungsebenen angewendet werden.

## Patentansprüche

1. Verfahren zum Messen von Teilentladungen, TE, an einer Vielzahl von gleichartigen Prüflingen (1) durch Anlegen einer variablen Prüfspannung definierter Wellenform an den jeweiligen, mit einer Meßimpedanz (2) in Reihe geschalteten Prüfling (1), wobei an der Meßimpedanz (2) der Teilentladungsimpuls, TE-Impuls, (UM) ausgekoppelt und anschließend über einen Hochpaß (21) einem Breitbandverstärker (22) zugeführt und durch diesen verstärkt wird, das verstärkte Signal (UM') über einen Tiefpaß (24) einem Analog-/Digitalwandler mit nachfolgendem Digitalspeicher (26) zugeführt und nach der Analog-/Digitalumwandlung digital gespeichert wird, dann die dem TE-Impuls entsprechenden, gespeicherten Daten einem Rechner (28) eingegeben werden und von diesem, insbesondere durch eine Fourier-Transformation, vom Zeitbereich in den Frequenzbereich transformiert und die berechneten digitalen Werte gespeichert werden, vor dem automatischen Meßvorgang entweder
- die Messung, Transformation und Speicherung an mehreren Muster-Bauteilen gleicher Bauart wie die zu messenden Prüflinge (1) durchgeführt und aus den gespeicherten, transformierten Daten ein für die Bauteil-Serie typisches Muster-TE-Frequenzspektrum gemittelt und gespeichert wird und als Referenz-TE-Frequenzspektrum (29) zur Verfügung steht oder
- ein typisches Muster-TE-Frequenzspektrum (29) synthetisch erzeugt wird und als Referenz-TE-Frequenzspektrum (29) zur Verfügung steht,
dann an einem Prüfling (1) die Messung, Transformation und Speicherung wenigstens eines auftretenden TE-Impulses durchgeführt wird und das bzw. die Prüflings-TE-Frequenzspektren (32, 33, 35, 37) an die Amplitudenwerte des Referenz-TE-Frequenzspektrums (29) angepaßt und anschließend mit diesem verglichen werden und ein Prüflings-TE-Impuls dann registriert wird, wenn dessen Frequenzspektrum (32, 33, 35, 37) innerhalb eines definierten Toleranzbereiches (30, 31) des Referenz-TE-Frequenzspektrums (29) liegt.

2. Verfahren nach Anspruch 1, dadurch gekennzeichnet, daß die Anpassung der Prüflings-TE-Impulse an das Referenz-TE-Frequenzspektrum (29) dadurch erfolgt, daß einmal für das Referenz-TE-Frequenzspektrum (29) und später für jedes Prüflings-TE-Frequenzspektrum (32, 33, 35, 37) ein 100%-Amplitudenwert berechnet, auf denjenigen des Referenz-TE-Frequenzspektrums (29) umgerechnet und dann die Amplitudenwerte für alle Frequenzen des Prüflings-TE-Impulses, auf den 100%-Amplitudenwert bezogen, berechnet werden.

3. Verfahren nach Anspruch 2, dadurch gekennzeichnet, daß für die Berechnung des 100%-Amplitudenwertes nur ein oder auch mehrere charakteristische Frequenzbereich(e) des Frequenzspektrums (29; 32, 33, 35, 37) herangezogen wird bzw. werden.

4. Verfahren nach Anspruch 3, dadurch gekennzeichnet, daß zur Berechnung des 100%-Amplitudenwertes der Frequenzbereich von etwa 10 kHz bis 100 kHz und der Frequenzbereich von etwa 3 MHz bis 3,1 MHz herangezogen werden.

5. Verfahren nach einem der Ansprüche 1 bis 4, dadurch gekennzeichnet, daß ein synthetisches Frequenzspektrum als Referenz-TE-Frequenzspektrum (29) verwendet wird.

6. Verfahren nach Anspruch 5, dadurch gekennzeichnet, daß die Muster-TE-Impulse bzw. Referenz-TE-Frequenzspektren (29) durch entsprechende Dateneingaben, insbesondere als mathematische Funktion oder in Form einer Wertetabelle, in dem Rechner (28) synthetisch erzeugt werden.

7. Verfahren nach Anspruch 5, dadurch gekennzeichnet, daß das synthetische Referenz-TE-Frequenzspektrum (29) aus synthetischen Muster-TE-Impulsen, insbesondere durch Einspeisen von durch einen Muster-Impuls-Generator (40) erzeugten Impulsen definierter Kurvenform in den Prüfaufbau, erzeugt wird.

8. Verfahren nach Anspruch 7, dadurch gekennzeichnet, daß die Muster-TE-Impulse von einem bei ausgeschalteter Prüfspannung parallel zum Prüfling (1) angeschlossenen Muster-Impuls-Generator (40) erzeugt werden.

9. Verfahren nach einem der Ansprüche 5 bis 8, dadurch gekennzeichnet, daß eine oder mehrere charakteristische Frequenz(en) bzw. ein oder mehrere charakteristische(r) Frequenzbereich(e) des nachgebildeten Referenz-TE-Frequenzspektrums (29) zur Ermittlung des 100%-Amplitudenwertes herangezogen wird bzw. werden.

10. Verfahren nach einem der Ansprüche 1 bis 9, dadurch gekennzeichnet, daß die TE-Frequenzspektren vor dem Vergleich und vor der Normierung auf einen 100%-Amplitudenwert auf markante, außerhalb der Toleranzgrenzen (30, 31) liegende Spitzenwerte (34.1, 36.1) untersucht und beim Vorhandensein solcher Spitzenwerte diese rechnerisch durch eine Korrekturroutine beseitigt werden und dann der 100%-Amplitudenwert ermittelt wird.

11. Verfahren nach einem der Ansprüche 1 bis 10, dadurch gekennzeichnet, daß die digitalisierten Prüflings-TE-Impulse vor ihrer Weiterverarbeitung mittels eines Rechenverfahrens, vorzugsweise mittels einer Autokorrelationsrechnung, auf periodische Störsignale (34) untersucht werden und diese mittels einer Korrekturroutine, beispielsweise eines digitalen Filters, beseitigt werden.

12. Verfahren nach einem der Ansprüche 1 bis 11, dadurch gekennzeichnet, daß der Störabstand der gespeicherten Prüflings-TE-Impulse vor deren Weiterverarbeitung durch ein Rechenverfahren, vorzugsweise durch eine Kreuzkorrelation mit einem wenig gestörten, insbesondere synthetisch erzeugten Musterimpuls, verbessert wird.

13. Verfahren nach einem der Ansprüche 1 bis 12, dadurch gekennzeichnet, daß der Einfluß des Quantisierungsrauschens auf die Prüflings-TE-Frequenzspektren (32, 33, 35, 37) durch Bewerten der Impulse mittels einer Fensterfunktion vermindert wird.

14. Verfahren nach einem der Ansprüche 1 bis 13, dadurch gekennzeichnet, daß zur Auskopplung des Prüflings-TE-Impulses als Meßimpedanz (2) ein koaxialer Rohrwiderstand verwendet wird.

15. Verfahren nach einem der Ansprüche 1 bis 13, dadurch gekennzeichnet, daß zur Auskopplung des Prüflings-TE-Impulses als Meßimpedanz (2) ein koaxialer Reusenwiderstand verwendet wird.

16. Verfahren nach einem der Ansprüche 1 bis 13, dadurch gekennzeichnet, daß zur Auskopplung des Prüflings-TE-Impulses als Meßimpedanz (2) ein Metallschichtwiderstand verwendet wird.

17. Verfahren nach einem der Ansprüche 1 bis 16, dadurch gekennzeichnet, daß ein Breitbandverstärker (22) mit einer Differenzverstärker-Eingangsstufe und mit einer Eingangsschutzschaltung (23a) gegen die impulsförmigen Überspannungen verwendet wird.

18. Verfahren nach einem der Ansprüche 1 bis 17, dadurch gekennzeichnet, daß markante, über einen Toleranzbereich (30, 31) hinausgehende Spitzen (34.1) des Frequenzspektrums (35) der TE-Impulse an die benachbarten Spektralanteile angepaßt werden.

19. Verfahren nach einem der Ansprüche 1 bis 18, dadurch gekennzeichnet, daß nach der Signalverarbeitung eines Prüflings-TE-Impulses dieser dann als solcher gewertet wird, wenn ein vorbestimmter Prozentsatz der Beträge der Spektralanteile innerhalb des Toleranzbereiches (30, 31) liegt.

20. Verfahren nach einem der Ansprüche 1 bis 19, dadurch gekennzeichnet, daß die Fast-Fourier-Transformation angewendet wird.

## Claims

1. A method of measuring partial discharges, TE , across a plurality of like specimens (1) by applying a variable test voltage of defined waveshape across the respective specimen (1) connected in series with a measuring impedance (2), the partial discharge pulse, the TB pulse being decoupled across the measuring impedance (2) and subsequently fed via a highpass filter (21) to a wideband amplifier (22) and amplified by it, the amplified signal (UM') being fed via a lowpass filter (24) to an analog-digital converter having a succeeding digital store (26) and after the analog-digital conversion being stored digitally, then the stored data corresponding with the TE-pulse are input to a computer (28) and transformed by it, in particular by a Fourier transformation, from the time range into the frequency range and the calculated digital values are stored, before the automatic measuring process either
- the measurement, transformation and storage are performed across a number of model components of the same construction as the specimens (1) which have to be measured and from the stored transformed data a model-TE-frequency spectrum typical of the component series is averaged and stored and is available as a reference-TE-frequency spectrum (29); or
- a typical model-TE-frequency spectrum (29) is generated synthetically and is available as a reference-TE-frequency spectrum (29);
then across one specimen (1) the measurement, transformation and storage is performed for at last one occurring TE-pulse, and the specimen-TE-frequency spectrum or spectra (32, 33, 35, 37) are adapted to the amplitude values of the reference-TE-frequency spectrum (29) and subsequently compared with the latter and then a specimen-TE-pulse is recorded if its frequency spectrum (32, 33, 35, 37) lies within a defined range of tolerance (30, 31) of the reference-TE-frequency spectrum (29).

2. A method as in Claim 1, characterized in that
the adaptation of the specimen-TE-pulse to the reference-TE-frequency spectrum (29) is effected by a 100%-amplitude value being calculated once for the reference-TE-frequency spectrum (29) and later for each specimen-TE-frequency spectrum (32, 33, 35, 37), converted to those of the reference-TE-frequency spectrum (29) and then the amplitude values for every frequency of the specimen-TE-pulse, referred to the 100%-amplitude value, are calculated.

3. A method as in Claim 2, characterized in that
for calculation of the 100%-amplitude value only one or else more characteristic frequency ranges of the frequency spectrum (29; 32, 33, 35, 37) are called upon.

4. A method as in Claim 3, characterized in that
for calculation of the 100%-amplitude value the frequency range of about 10 kHz to 100 kHz and the frequency range of about 3 MHz to 3.1 MHz are called upon.

5. A method as in one of the Claims 1 to 4, characterized in that
a synthetic frequency spectrum is employed as reference-TE-frequency spectrum (29).

6. A method as in Claim 5, characterized in that
the model-TE-pulses or respectively the reference-TE-frequency spectra (29) are generated synthetically in the computer (28) through appropriate data inputs, especially as a mathematical function or in the form of a table of values.

7. A method as in Claim 5, characterized in that
the synthetic reference-TE-frequency spectrum (29) is generated from synthetic model-TE-pulses, in particular through feeding in pulses of defined contour generated by a model-pulse generator (40) in the build-up of the test.

8. A method as in Claim 7, characterized in that
the model-TE-pulses are generated by a model-pulse generator (40) which is connected in parallel with the specimen (1) with the test voltage switched off.

9. A method as in one of the Claims 5 to 8, characterized in that
one or more characteristic frequencies or one or more characteristic frequency ranges of the copied reference-TE-frequency spectrum (29) are called upon for the determination of the 100%-amplitude value.

10. A method as in one of the Claims 1 to 9, characterized in that
before comparison and before standardization to one 100%-amplitude value the TE-frequency spectra are examined for peak values (34.1, 36.1) which are outstanding and lie outside the limits of tolerance (30, 31), and where such peaks values are present they are eliminated by computer by a correction routine and then the 100%-amplitude value is determined.

11. A method as in one of the Claims 1 to 10, characterized in that
before further processing of the digitalized specimen-TE-pulses by means of a method of calculation, preferably by means of an autocorrelation calculation, they are examined for periodic interference signals (34) and these are eliminated by means of a correction routine, for example, a digital filter.

12. A method as in one of the Claims 1 to 11, characterized in that
the signal-to-noise ratio of the stored specimen-TE-pulses is improved before their further processing through a method of calculation, preferably through cross-correlation with a little disturbed specimen pulse, especially one synthetically generated.

13. A method as in one of the Claims 1 to 12, characterized in that
the influence of the quantization noise upon the specimen-TE-frequency spectra (32, 33, 35, 37) is reduced through evaluation of the pulses by means of a window function.

14. A method as in one of the Claims 1 to 13, characterized in that
for decoupling the specimen-TE-pulse a coaxial tubular resistor is employed as the measuring impedance (2).

15. A method as in one of the Claims 1 to 13, characterized in that
for decoupling the specimen-TE-pulse a coaxial pyramidal resistor is employed as the measuring impedance (2).

16. A method as in one of the Claims 1 to 13, characterized in that
for decoupling the specimen-TE-pulse a metal layer resistor is employed as the measuring impedance (2).

17. A method as in one of the Claims 1 to 16, characterized in that a wideband amplifier (22) is employed, with a differential amplifier input stage and having an input circuit (23a) protective against the pulseshaped overvoltages.

18. A method as in one of the Claims 1 to 17, characterized in that
peaks (34.1) of the frequency spectrum (35) of the TE-pulses, which are outstanding and exceed a range of tolerance (30, 31), are adapted to the adjacent portions of spectrum.

19. A method as in one of the Claims 1 to 18, characterized in that
after the signal processing of one specimen-TE-pulse the latter is valued as such when a predetermined percentage of the amounts of the portions of spectrum lies within the range of tolerance (30, 31).

20. A method as in one of the Claims 1 to 19, characterized in that
the Fast-Fourier transformation is applied.

## Revendications

1. Procédé de mesure de décharges partielles TE , d'une multiplicité d'échantillons (1) de même nature, par application d'une tension de contrôle variable à forme d'onde définie pour chaque échantillon, un échantillon (1) étant branché en série sur une impédance de mesure (2), l'impulsion de décharge partielle TE (UM) étant découplée de l'impédance de mesure pour être appliquée à travers un filtre passe-haut (21) à un amplificateur en bande large (22) pour être amplifiée par celui-ci et le signal amplifié (UM') est fourni à travers un filtre passe-bas (24) à un convertisseur analogique/numérique suivi d'une mémoire numérique (26) pour être mis en mémoire numérique après conversion analogique/numérique, puis les données mises en mémoire, correspondant à l'impulsion TE, sont fournies à un calculateur (28) qui les transforme notamment par une transformation de Fourier de la plage de temps à la plage de fréquence et on enregistre les valeurs numériques avant l'opération de mesure automatique,
caractérisé en ce qu'
- on effectue la mesure, la transformation, la mise en mémoire, sur plusieurs pièces de modèles de construction, de même construction que les échantillons (1) à mesurer et à partir des données transformées mises en mémoire, on forme la moyenne et on met en mémoire comme spectre de fréquence modèle TE (29) caractéristique de la série des pièces, ou
- on dispose d'un spectre de fréquence de modèle TE (29) caractéristique, obtenu par synthèse et servant de spectre de fréquence de référence TE (29),
- puis on effectue sur un échantillon (1), la mesure, la transformation et la mise en mémoire d'au moins une impulsion TE qui se produit et on adapte le ou les spectres de fréquence d'échantillons TE (32, 33, 35, 37) aux valeurs d'amplitude du spectre de fréquence de référence TE (29), on compare avec celui-ci et on enregistre une impulsion d'échantillon TE si son spectre de fréquence (32, 33, 35, 37) se situe à l'intérieur d'une plage de tolérance (30, 31) déterminée du spectre de fréquence de référence TE (29).

2. Procédé selon la revendication 1,
caractérisé en ce que
l'adaptation des impulsions de l'échantillon TE se fait sur le spectre de fréquence de référence TE (29) en ce que d'une part pour le spectre de fréquence de référence TE (29), puis pour chaque spectre de fréquence d'ébauche TE (32, 33, 35, 37) on calcule une valeur d'amplitude à 100 %, on convertit par calcul sur le spectre de fréquence de référence TE (29) et on calcule alors la valeur des amplitudes pour toutes les fréquences de l'impulsion d'échantillon TE rapportée à une valeur d'amplitude à 100 %.

3. Procédé selon la revendication 2,
caractérisé en ce que
pour le calcul de la valeur d'amplitude à 100 %, on utilise seulement une ou plusieurs plages de fréquence caractéristiques du spectre de fréquence (29; 32, 33, 35, 37).

4. Procédé selon la revendication 3,
caractérisé en ce que
pour le calcul de la valeur d'amplitude à 100 %, on utilise une plage de fréquence comprise entre environ 10 kHz et 100 kHz et une plage de fréquence comprise entre environ 3 MHz et 3,1MHz.

5. Procédé selon l'une des revendications 1 à 4,
caractérisé en ce qu'
on utilise un spectre de fréquence de synthèse comme spectre de fréquence de référence TE (29).

6. Procédé selon la revendication 5,
caractérisé en ce qu'
on génère par synthèse les impulsions modèle TE ou les spectres de fréquence de référence TE (29) par l'introduction de données correspondantes, notamment sous la forme d'une fonction mathématique ou d'un tableau de valeurs dans le calculateur (28).

7. Procédé selon la revendication 5,
caractérisé en ce qu'
on génère le spectre de fréquence de référence TE (29) de synthèse à partir des impulsions modèles TE de synthèse, notamment en fournissant au contrôle de l'échantillon une forme de courbe définie par les impulsions données par un générateur d'impulsions modèles (40).

8. Procédé selon la revendication 7,
caractérisé en ce qu'
on génère les impulsions modèles TE à partir d'un générateur d'impulsions de modèles (40) raccordé en parallèle à l'échantillon (1) lorsque la tension de contrôle est coupée.

9. Procédé selon l'une des revendications 5 à 8,
caractérisé en ce qu'
on utilise une ou plusieurs fréquences caractéristiques ou une ou plusieurs plages de fréquences caractéristiques du spectre de fréquence de référence TE (29), copié, pour déterminer la valeur d'amplitude à 100 %.

10. Procédé selon l'une des revendications 1 à 9,
caractérisé en ce qu'
on examine les spectres de fréquence TE avant la comparaison et avant la normalisation à une valeur d'amplitude de 100 %, pour déterminer les valeurs maximales, marquantes (34.1, 36.1) situées à l'extérieur des plages de tolérance (30, 31), et en cas de telles valeurs maximales, on les élimine par le calcul à l'aide d'un programme de correction et on détermine alors la valeur d'amplitude à 100 %.

11. Procédé selon l'une des revendications 1 à 10,
caractérisé en ce que
les impulsions d'échantillon TE numérisées sont examinées avant la poursuite de leur traitement à l'aide d'un procédé de calcul, de préférence par un calcul d'auto-corrélation pour trouver les signaux parasites périodiques (34) et on élimine ces signaux par un programme de correction, par exemple un filtre numérique.

12. Procédé selon l'une des revendications 1 à 11,
caractérisé en ce qu'
on améliore la bande parasite des impulsions d'échantillon TE mises en mémoire avant la poursuite de leur traitement par un procédé de calcul, de préférence par une corrélation croisée avec une impulsion modèle faiblement parasitée, générée notamment par synthèse.

13. Procédé selon l'une des revendications 1 à 12,
caractérisé en ce qu'
on diminue l'influence du bruit de quantification sur les spectres de fréquence d'échantillon TE (32, 33, 35, 37) en exploitant les impulsions à l'aide d'une fonction de fenêtre.

14. Procédé selon l'une des revendications 1 à 13,
caractérisé en ce que
pour découpler les impulsions d'ébauche TE on utilise une résistance tubulaire coaxiale comme impédance de mesure (2).

15. Procédé selon l'une des revendications 1 à 13,
caractérisé en ce que
pour découpler l'impulsion d'échantillon TE, on utilise une résistance en nasse, coaxiale comme impédance de mesure (2).

16. Procédé selon l'une des revendications 1 à 13,
caractérisé en ce que
pour découpler l'impulsion d'ébauche TE, on utilise une résistance à couche métallique comme impulsion de mesure (2).

17. Procédé selon l'une des revendications 1 à 16,
caractérisé en ce qu'
on utilise un amplificateur en bande large (22) avec un étage d'entrée d'amplificateur de différence et un circuit de protection d'entrée (23a) contre les surtensions impulsionnelles.

18. Procédé selon l'une des revendications 1 à 17,
caractérisé en ce que
les pointes (34.1) marquantes, dépassant la plage de tolérance (30, 31) du spectre de fréquence (35) des impulsions TE sont adaptées aux composantes spectrales voisines.

19. Procédé selon l'une des revendications 1 à 18,
caractérisé en ce qu'
après le traitement du signal d'une impulsion d'échantillon TE, on exploite celle-ci en tant que telle lorsqu'un pourcentage prédéterminé des valeurs des composantes spectrales se situe dans la plage de tolérance (30, 31).

20. Procédé selon l'une des revendications 1 à 19,
caractérisé en ce qu'
on applique une transformation de Fourier rapide.
